# EUROPEAN PATENT APPLICATION

(11) **EP 3 450 075 A1**
(43) Date of publication of application: **06.03.2019**
(21) Application number: 18185972.9
(22) Date of filing: 27.07.2018
(51) Int. Cl.: B23K 9/09, B23K 9/12, B23K 9/173, B23K 9/32

(54) **WELDING POWER SUPPLY WITH A CONTROLLER FOR IDENTIFICATION OF REMOTE SWITCH OPERATION**

(30) Priority: 28.07.2017 US 201715662443
(71) Applicant: Lincoln Global, Inc., Santa Fe Springs, CA 90670 (US)
(72) Inventor: HENRY, Judah Benjamin, Palnesville, OH 44077 (US); FLEMING, Daniel P., Painesville, OH Ohio 44077 (US)
(74) Representative: Grosse Schumacher Knauer von Hirschhausen

(57) **Abstract**

A welding system (10) includes a power supply (12) configured to output a series of welding waveforms for generating a welding current in a consumable welding electrode (28), and a wire feeder (14) that advances the electrode (28) toward a weld puddle during a welding operation. The wire feeder (14) includes a subcircuit (38) having a switching device (22) and parallel resistance, the subcircuit (38) being connected in series with the electrode (28) such that the welding current flows through the subcircuit (38). The switching device (22) is controllable between conducting and nonconducting states. The wire feeder (14) includes a controller (24, 46) operatively connected to the switching device(22) that controls switching operations of the switching device (22). The power supply (12) is configured to remotely identify occurrences of the switching operations in the wire feeder (14) and control the welding waveforms based on the occurrences of the switching operations.

## Description

### FIELD OF THE INVENTION

The invention is related to a welding system according to claim 1, 6 and 11. Embodiments of the present invention relate to electric arc welding systems having a wire feeder located at a point of use near a workpiece, and a remote power supply that is connected to the wire feeder. The remote power supply generates welding waveforms for performing a welding operation on the workpiece.

### TECHNICAL BACKROUND

It is known to perform electric arc welding using periodic welding waveforms having pulses of current separated by lower current portions to achieve desired metal transfer and final weld properties. The periodic welding waveforms can be used in both pulse arc welding in which the welding electrode does not short against the workpiece, and in short circuit welding. One short circuit welding technique that uses periodic welding waveforms is Surface Tension Transfer (STT). In STT welding, a consumable wire electrode is energized by a welding power supply as it is driven toward a workpiece by a wire feeder. Background current establishes an arc between the wire electrode and the workpiece, and produces a molten ball at the end of the electrode. The molten ball is moved toward the workpiece by the wire feeder and eventually shorts against the workpiece, extinguishing the arc. A controlled pinch current that is greater than the background current causes the molten ball to pinch off from the wire electrode, and a subsequent plasma boost pulse is applied to the welding electrode to set the proper arc length and push the weld puddle away from the wire electrode. The various portions of the periodic welding waveform are repeated in sequence during welding under the control of a microprocessor-based controller, which controls the operation of high-frequency switching components (e.g., inverter, choppers, etc.) in the power supply to produce the desired waveforms. The controller, which is located in the welding power supply, relies on welding voltage measurements to determine when to apply the different portions of the STT welding waveform.

When the welding power supply is located near the workpiece to be welded, STT welding can be satisfactorily performed by the power supply because the inductance of the welding cables is relatively small and the welding voltage can be accurately measured by the power supply. However, as the power supply is moved further away from workpiece, such as 100 feet or more for example, STT welding becomes more difficult. In such a scenario, the inductance of the long welding cables can be 65 µH or more, which can result in inaccurate welding voltage measurements by the power supply. It would be desirable to perform satisfactory STT welding when the power supply is located remote from the workpiece and the inductance of the welding cables in the welding circuit is large.

### DESCRIPTION

In order to improve welding, especially STT welding, a welding system according to claim 1 is described and according to claim 6 and 11. Preferred embodiments are subject of the subclaims. The following summary presents a simplified summary in order to provide a basic understanding of some aspects of the devices, systems and/or methods discussed herein. This summary is not an extensive overview of the devices, systems and/or methods discussed herein. It is not intended to identify critical elements or to delineate the scope of such devices, systems and/or methods. Its sole purpose is to present some concepts in a simplified form as a prelude to the more detailed description that is presented later.

In accordance with one aspect of the present invention, provided is a welding system including a power supply configured to output a series of welding waveforms for generating a welding current in a consumable welding electrode, and a wire feeder that advances the consumable welding electrode toward a weld puddle during a welding operation. The wire feeder comprises a subcircuit comprising a switching device and parallel resistance, said subcircuit being connected in series with the consumable welding electrode such that the welding current flows through the subcircuit, wherein the switching device is controllable between a conducting state and a nonconducting state. The wire feeder comprises a controller operatively connected to the switching device that is configured to control switching operations of the switching device. The power supply is configured to remotely identify occurrences of the switching operations in the wire feeder and control the welding waveforms based on the occurrences of the switching operations.

In accordance with another aspect of the present invention, provided is a welding system including a power supply configured to control a first portion of a welding waveform and a second portion of a welding waveform, for generating a welding current in a consumable welding electrode. The welding system includes a wire feeder that advances the consumable welding electrode toward a weld puddle during a welding operation. The wire feeder comprises a subcircuit comprising a switching device and parallel resistance, said subcircuit being connected in series with the consumable welding electrode such that the welding current flows through the subcircuit. The switching device is controllable between a conducting state and a nonconducting state. The wire feeder comprises a controller operatively connected to the switching device that is configured to control switching operations of the switching device between the conducting state and the nonconducting state to generate a low current portion of the welding waveform between the first portion of the welding waveform and the second portion of the welding waveform. The power supply comprises a welding current sensor, and the power supply is configured to determine occurrences of the switching operations in the wire feeder based on sensed welding current and control a timing of at least one of the first portion of the welding waveform and the second portion of the welding waveform with respect to the low current portion.

In accordance with another aspect of the present invention, provided is a welding system including a power supply comprising an inverter controlled to generate a series of welding waveforms, and a wire feeder, located remote from the power supply, that advances a consumable welding electrode toward a weld puddle during a welding operation. The consumable welding electrode is operatively connected to the power supply to conduct a welding current comprising the welding waveforms to a workpiece. The welding system includes a subcircuit comprising a switching device and parallel resistance, said subcircuit being connected in series with the consumable welding electrode such that the welding current flows through the subcircuit. The switching device is controllable between a conducting state and a nonconducting state. A controller is operatively connected to the switching device and configured to control switching operations of the switching device. The controller and subcircuit are located remote from the power supply and local to the wire feeder. The power supply the power is configured to remotely identify occurrences of the switching operations of the switching device and control timing of operations of the inverter with respect to the switching operations of the switching device.

### BRIEF DESCRIPTION OF THE DRAWINGS

FIG. 1 is a perspective view of an example welding system;
FIG. 2 is a block diagram of the example welding system;
FIG. 3 is a schematic diagram of the example welding system;
FIG. 4 is an example welding waveform;
FIG. 5 is a schematic diagram of a portion of an example welding system; and
FIG. 6 a block diagram of an example welding system.

### DETAILED DESCRIPTION

Embodiments of the present invention relate to electric arc welding systems having a wire feeder located at a point of use near a workpiece, and a remote power supply that is connected to the wire feeder. The present invention will now be described with reference to the drawings, wherein like reference numerals are used to refer to like elements throughout. It is to be appreciated that the various drawings are not necessarily drawn to scale from one figure to another nor inside a given figure, and in particular that the size of the components are arbitrarily drawn for facilitating the understanding of the drawings. In the following description, for purposes of explanation, numerous specific details are set forth in order to provide a thorough understanding of the present invention. It may be evident, however, that the present invention can be practiced without these specific details. Additionally, other embodiments of the invention are possible and the invention is capable of being practiced and carried out in ways other than as described. The terminology and phraseology used in describing the invention is employed for the purpose of promoting an understanding of the invention and should not be taken as limiting.

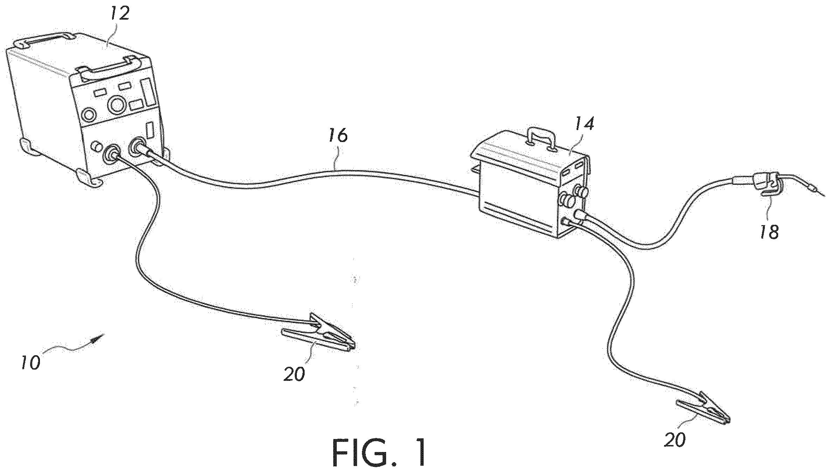

Figure 1 shows an example welding system 10 that includes a welding power supply 12 and a wire feeder 14. The power supply 12 receives input power, such as from a utility or generator source, and generates welding waveforms for performing a welding operation on a workpiece (not shown). Welding power is supplied by the power supply 12 to the wire feeder 14 over a power cable 16. It can be seen that the power supply 12 and wire feeder 14 are enclosed in separate housings and are placed apart from one another. The wire feeder 14 can be located at a point of use near a workpiece to be welded, remote from the power supply 12, such as several hundred feet away from the power supply. The wire feeder 14 conducts welding current, feeds consumable welding electrode wire, and optionally supplies shielding gas, to a welding torch 18. The power supply 12 and wire feeder 14 can include grounding clamps 20 to complete the arc welding electrical circuit.

The power supply 12 includes a user interface for setting various welding parameters, such as voltage, current, the welding process, etc. The wire feeder 14 can also include a user interface for adjusting similar parameters remote from the power supply 12. The power supply and wire feeder 14 can be configured to communicate bidirectionally with each other. Such communications can occur over the power cable 16, wirelessly, or via additional hardwired communication cables. An operator can make adjustments to welding parameters locally at the wire feeder 14, and the wire feeder can communicate welding parameter adjustments to the power supply (e.g., over the power cable 16).

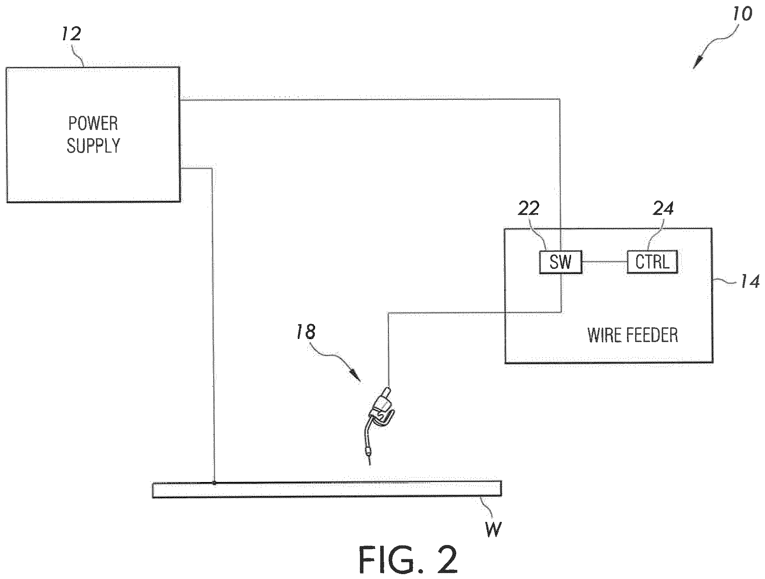

As noted above, when the power supply 12 is located remote from the point of use, STT welding becomes difficult, due to the inductance of the long power cable 16 (e.g., 65 µH or more) causing inaccurate welding voltage measurements at the power supply. A power circuit for STT welding includes a switch ("STT switch" - typically a transistor switch) and parallel resistance connected in series with the welding electrode. The STT switch is normally closed (e.g., in an on or conducting state) and welding current flows directly through the switch. However, the STT switch can be temporarily opened or deactivated to force the welding current through its parallel resistor, to quickly pull the welding current to a low level during certain portions of the welding waveform (e.g., upon the welding electrode shorting against the workpiece, and to prevent an explosive detaching of a molten ball on the end of the electrode). The operations of the STT switch are controlled based on a sensed welding condition, such as voltage. However, the power supply 12 cannot sense welding voltage accurately enough to properly control the STT switch when the power cable 16 introduces a large inductance into the welding circuit. To accommodate STT welding when the power supply 12 is located remote from the workpiece W (see Fig. 2), the STT switch 22 and its parallel resistance have been moved local to the wire feeder 14 much nearer to the workpiece. The wire feeder 14 includes a controller 24 that monitors welding voltage locally at the workpiece W, so that the long power cable from the power supply 12 does not affect the accuracy of the welding voltage measurement. The controller 24 controls the operations of the STT switch based on the sensed welding voltage. Thus, the wire feeder 14, and not the power supply 12, generates the low current portions of the welding waveform by opening the STT switch at appropriate times. The power supply 12 monitors welding current to determine occurrences of the switching operation of the STT switch in the wire feeder 14, and uses such occurrences as synchronizing or timing signals in order to properly control the timing of other portions of the welding waveform that are generated by the power supply.

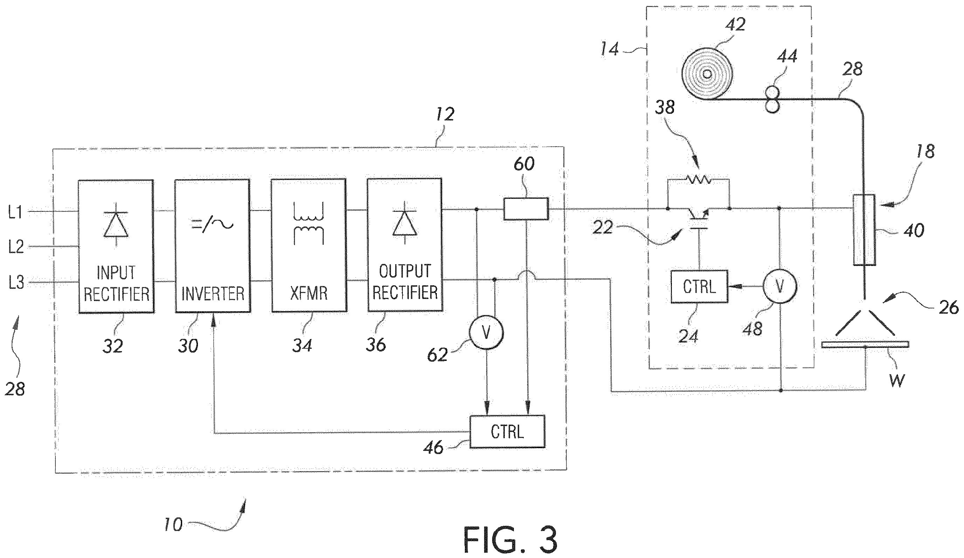

A more detailed schematic diagram of an example arc welding system 10 is shown in Fig. 3. The arc welding system 10 includes the welding power supply 12 and wire feeder 14. The welding power supply 12 outputs a series of welding waveforms for generating a welding current and creating an electric arc 26 between a consumable welding electrode 28 and a workpiece W, to perform an arc welding operation on the workpiece.

For purposes of explanation, the disclosed subject matter is discussed in the context of an arc welding operation that uses a driven wire consumable electrode (e.g., gas metal arc welding (GMAW), flux-cored arc welding (FCAW), submerged arc welding (SAW)). However, it is to be appreciated that the disclosed subject matter could be applicable to other types of arc welding, such as gas tungsten arc welding (GTAW) for example.

The welding power supply 12 receives electrical energy for generating the arc 26 from a power source 28, such as a commercial power source or a generator. The power source 28 can be a single phase or three phase power source. In certain embodiments, the arc welding system 10 can be a hybrid system that includes one or more batteries (not shown) that also supply energy to the welding power supply 12.

The welding power supply 12 includes a switching type power converter such as an inverter 30 for generating the arc 26 according to a desired welding waveform. Alternatively or additionally, the welding power supply 12 could include a DC chopper (not shown) or boost converter (not shown) for generating welding waveforms. AC power from the power source 28 is rectified by an input rectifier 32. The DC output from the rectifier 32 is supplied to the inverter 30. The inverter 30 supplies high-frequency AC power to a transformer 34, and the output of the transformer is converted back to DC by an output rectifier 36. The output rectifier 36 supplies the electrical power for generating the arc 24 through either the STT switch 22 or through its parallel resistor 38 at the wire feeder 14.

The arc welding system 10 can include a welding torch 18 that is operatively connected to the power supply 12 via the wire feeder 14. The power supply 12 supplies welding output electrical energy to the welding torch 18, through the STT switch 22 or parallel resistor 38, to generate the arc 26 and perform the welding operation. In Fig. 3, the torch 18 has a contact tip 40 for transferring the electrical energy supplied by the power supply 12 to the consumable welding electrode 28.

The consumable welding electrode 28 can be fed from a spool of wire 42 at the wire feeder 14 by motor-operated pinch rollers 44 in the wire feeder. The motor-operated pinch rollers 44 advance the electrode toward a weld puddle during the welding operation, at a wire feed speed (WFS). The WFS may be controlled by the controller 24 that is coupled to the STT switch 22, or by a separate wire feeder controller.

The arc welding system 10 can be configured for direct current electrode positive (DC+) or "reverse" polarity wherein the contact tip 40 and electrode 28 are connected to a positive lead from the power supply 12, and the workpiece W is connected to a negative lead. Alternatively, the arc welding system 10 can be configured for direct current electrode negative (DC-) or "straight" polarity, wherein the workpiece W is connected to the positive lead and the contact tip 40 and electrode 28 are connected to the negative lead. Further, the arc welding system 10 can be configured for AC welding in which AC waveforms are provided to the contact tip 40, electrode 28 and workpiece W.

The power supply 12 includes a controller 46 that is operatively connected to the inverter 30 for controlling the welding waveforms generated by the power supply. The controller 46 can provide a waveform control signal to the inverter 30 to control its output so as to generate the welding waveforms, or portions of welding waveforms (e.g., portions not controlled by the STT switch and parallel resistor 22). The controller 46 controls the output of the inverter 30 via the waveform control signal, to achieve a desired welding waveform, welding voltage, welding current, etc. The waveform control signal can comprise a plurality of separate control signals for controlling the operation of various switches (e.g., transistor switches) within the inverter 30.

The controllers 24, 46 can be electronic controller and may include a processor. The controllers 24, 46 can include one or more of a microprocessor, a microcontroller, a digital signal processor (DSP), an application specific integrated circuit (ASIC), a field-programmable gate array (FPGA), discrete logic circuitry, or the like. The controllers 24, 46 can include memory portions (e.g., RAM or ROM) storing program instructions that cause the controller to provide the functionality ascribed to it herein. The controllers 24, 46 can include a plurality of physically separate circuits or electronic devices, such as a processor in combination with separate comparators, logic circuits, etc. However, for ease of explanation, the controllers 24, 46 are shown as monolithic devices.

The controller 24 in the wire feeder 14 is operatively connected to the STT switch 22 to control its switching operations between an on or conducting state and an off or nonconducting state. The resistor 38 is connected in parallel with the STT switch 22, thereby forming a subcircuit within the wire feeder 14 that is connected in series with the consumable welding electrode 28. The operation of the subcircuit, in particular the switching operations of the STT switch 22, are controlled by the controller 24 based on a sensed welding condition, such as voltage, current, power, time or a combination of welding conditions. When the STT switch 22 is in the on or conducting state, the welding current flows through the STT switch to the torch 18 and electrode 28. When in the on or conducting state, the STT switch 22 effectively shorts out the resistor 38. When the STT switch 22 is in an off or nonconducting state, the resistor 38 is connected in series with the torch 18 and consumable welding electrode 28, and the welding current flows through the resistor to the torch and electrode. The magnitude of the welding current can be quickly reduced to a low level that is determined by the resistor 38, by turning off the STT switch 22 and forcing the welding current through the resistor 38.

The wire feeder 14 includes a voltage sensor 48 for monitoring welding voltage controller 46. The voltage sensor 48 provides a voltage signal to the controller 24, and based on the sensed welding voltage and/or other sensed welding conditions, the controller controls the switching operations of the STT switch 22. In particular, the controller 24 turns the STT switch 22 off to initiate low current portions of the welding waveform, and turns the STT switch 22 on to end the low current portions of the welding waveform. The controller 24 can determine when to activate/deactivate the STT switch 22 based on the level of the voltage signal, or from a parameter derived from the voltage signal, such as dV/dt (rate of change of welding voltage).

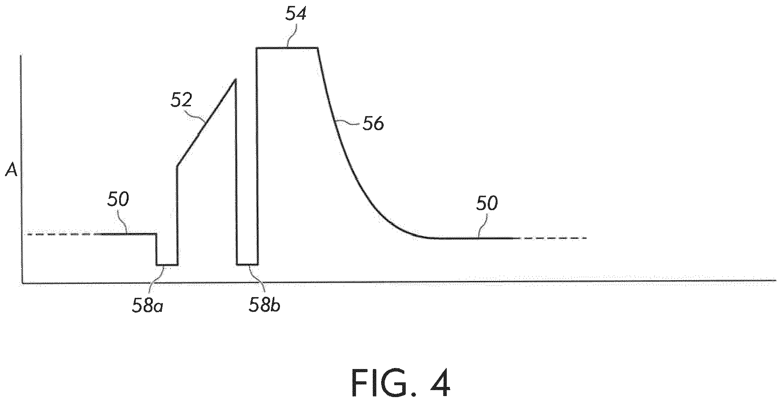

An example welding waveform that can be generated by the power supply 12, in conjunction with the STT switch 22 and parallel resistor 38 subcircuit in the wire feeder, is shown in Fig. 4. The waveform in Fig. 4 is an STT waveform. However, the present invention is not limited to STT waveforms and would be applicable to any welding waveforms that would benefit from a quick transition from a higher current level to a lower current level. The STT waveform includes a background current portion 50, a pinch current portion 52, and a plasma boost pulse 54 followed by a tail out 56 to another background current portion. Between the background current portion 50 and the pinch current portion 52, and between the pinch current portion 52 and the plasma boost pulse 54, are minimum current portions 58a, 58b. It can be seen that the background current portion 50 has a greater magnitude than the minimum current portions 58a, 58b, but less than the pinch current portion 52 and the plasma boost pulse 54 (e.g., peak current portion of the example waveform). The STT switch 22 (Fig. 3) is in the on or conducting state during the background 50, pinch 52 and plasma boost pulse 54 portions of the welding waveform, and the welding current flows through the STT switch during these portions. The background 50, pinch 52 and plasma boost pulse 54 portions of the welding waveform are generated by the power supply 12. The STT switch 22 is in the off or nonconducting state during the minimum current portions 58a, 58b, and the welding current flows through the resistor 38 during the minimum current portions. The magnitude of the minimum current portions 58a, 58b are determined by the resistor 38.

During the background current portion 50, a molten ball forms on the end of the electrode 28, and the electrode can short to the weld puddle. The controller 24 in the wire feeder 14 can recognize the existence of the short by monitoring the welding voltage signal. When a short is detected (e.g., based on dV/dt indicating a rapid drop in welding voltage), the controller 24 quickly reduces the welding current to the minimum current level by turning off the STT switch 22. Reducing the welding current helps to ensure a solid short and avoids blowing apart the electrode like a fuse. The first minimum current portion 58a can be for a fixed duration, after which the controller 24 switches the STT switch 22 from the nonconducting to the conducting state.

The controller 46 in the power supply 12 can monitor aspects of the welding process via feedback signals from welding condition sensors. For example, a welding current sensor, such as a current transformer (CT) or shunt 60, can provide a welding current feedback signal to the controller 46, and a voltage sensor 62 can provide a voltage feedback signal to the controller. The controller 46 needs to remotely identify when the STT switch 22 in the wire feeder 14 turns off and on in order to control the timing of portions of the welding waveform generated by the inverter 30 (e.g., the background 50, pinch 52 and plasma boost pulse 54 portions). The wire feeder 14 could communicate the switching events to the power supply 12, such as wirelessly or over the power cable, so that the power supply can identify he switching operations from the communications and control the timing of portions of the welding waveform. Alternatively, the controller 46 can monitor one or more welding conditions (e.g., current, power, etc.) to identify or determine the occurrence of switching operations of the STT switch. For example, the power supply can monitor the welding current feedback signal to determine occurrences of the switching operations of the STT switch 22. The controller 46 can determine occurrences of the switching operations of the STT switch 22 based on the welding current level, or from a parameter derived from the welding current feedback signal, such as dl/dt (rate of change of welding current). For example, when dl/dt indicates a rapid reduction in welding current, the controller 46 determines that the STT switch 22 has switched from the conducting to the nonconducting state. When dl/dt indicates a rapid increase in welding current, the controller 46 determines that the STT switch 22 has switched from the nonconducting to the conducting state.

The power supply 12 uses the determined switching occurrences of the remote STT switch 22, via welding current dl/dt analysis for example, as synchronizing signals to control the timing of portions of the welding waveforms. The power supply 12 and wire feeder 14 can work in concert to generate the welding waveforms, with the wire feeder generating low or minimum current portions based on the welding voltage, and the power supply controlling the timing of other, high current portions of the welding waveforms based on determined occurrences of the switching operations of the remote STT switch 22 (the switching occurrences being inferred by the controller 46 from changes to the welding current).

The controller 46 determines that the first minimum current portion 58a has ended when the welding current dl/dt shows a rapidly-increasing welding current. Upon determining that the first minimum current portion 58a has ended (i.e., the STT switch 22 is again in a conducting state), the controller 46 controls the inverter 30 to generate a pinch current 52 to neck down the end of the electrode 28 for separation into the weld puddle. The electrode 28 is shorted to the weld puddle during the pinch current 52 portion of the welding waveform. Just before the short is cleared, the controller 24 in the wire feeder 14 again turns off the STT switch 22 to quickly reduce the welding current to the second minimum current portion 58b (to prevent spatter when the molten ball pinches off of the electrode and to promote arc stability). By monitoring the welding voltage and/or the rate of change of welding voltage, the controller 24 in the wire feeder 14 can determine that the molten ball is about the separate from the electrode 28 and, thus, control the timing of the switching operation of the STT switch 22. The controller 46 in the power supply 12 recognizes the switching off of the STT switch 22 from a rapid drop in the welding current.

The controller 24 in the wire feeder 14 can determine that the arc is reestablished by monitoring the welding voltage. When the arc is reestablished (or after a duration of time chosen to prevent unnecessary stubbing the welding electrode 28), the controller 24 in the wire feeder 14 switches the STT switch 22 back to its conducting state. The controller 46 in the power supply 12 determines that the second minimum current portion 58b has ended when the welding current dl/dt shows a rapidly-increasing welding current. Upon determining that the STT switch 22 has switched from the nonconducting state to the conducting state from the welding current dl/dt, the controller 46 in the power supply 12 controls the inverter 30 to generate a peak current (plasma boost pulse 54) portion of the welding waveform to set the proper arc length and push the weld puddle away from the wire electrode. The plasma boost pulse 54 is then tailed out 56 by the controller 46, to return the welding current to the background current 50 level. The STT waveform can be repeated by the power supply 12 and wire feeder 14 acting in concert as described above.

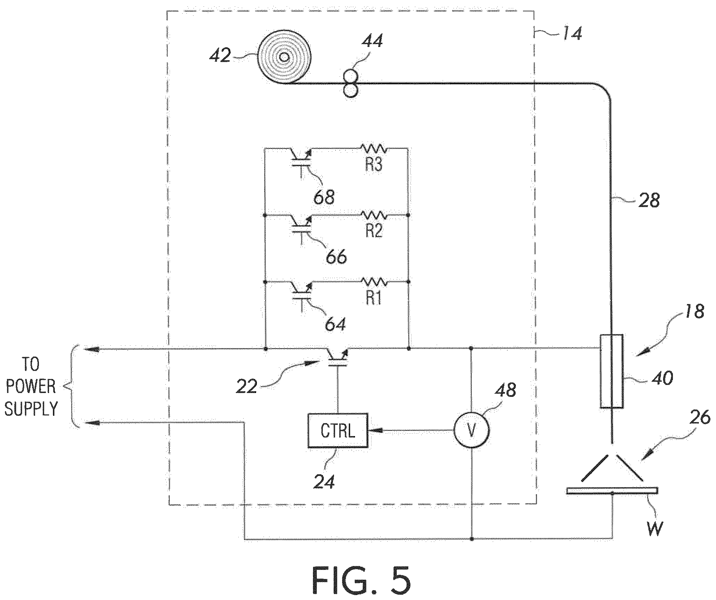

In certain embodiments, the resistor 38 can be an adjustable resistance to allow for selective adjustment of the minimum welding current level. The magnitude of minimum current portions 58a, 58b of welding waveforms can be controlled and adjusted via the adjustable resistance (e.g., by increasing or decreasing the resistance level of the adjustable resistance). An example adjustable resistance is shown in Fig. 5. The adjustable resistance can include an array of individually switched resistances R1, R2, R3 connected in parallel. In the example shown in Fig. 5, the adjustable resistance includes three individually switched resistances connected in parallel; however, the adjustable resistance could include more or fewer than three individually switched resistances, depending on the number of desired minimum current levels available for selection. The values or magnitudes of the resistors R1, R2, R3 can be different from each other or the same. Example values for the resistors are 50 Ohms or less, 20 Ohms or less (e.g., 20 Ohms, 15 Ohms, 10 Ohms, 5 Ohms, 2.5 Ohms, 1.25 Ohms, etc.) and 10 Ohms or less (e.g., 10 Ohms, 5 Ohms, 2.5 Ohms, 1.25 Ohms, etc.)

The activation of some or all of the resistors R1, R2, R3 can be controlled by respective switches 64, 66, 68. The operation of the switches 64, 66, 68, which can be transistor switches or other types of controllable switches, are controlled by the controller 24 in the wire feeder 14. In the example of Fig. 5, the adjustable resistance comprises a series connection of a first transistor switch 64 and a first resistor R1, a series connection of a second transistor switch 66 and a second resistor R2, and a series connection of a third transistor switch 68 and a third resistor R3, with the series connection of the first transistor switch and the first resistor being connected in parallel with the series connection of the second transistor switch and the second resistor, and also connected in parallel with the series connection of the third transistor switch and the third resistor.

The controller 24 can set the resistance level of the adjustable resistance by selectively switching in one or more of the resistors R1, R2, R3, to thereby set the magnitude of the minimum current portions of the welding waveform. If the resistors R1, R2, R3 each have respective different resistance values (e.g., 5 Ohms, 2.5 Ohms, 1.25 Ohms), seven different minimum current magnitudes can be obtained by following combinations: R1 only, R2 only, R1 II R2 (R1 and R2 switched on = 1.67 Ohms), R3 only, R1 II R3 (R1 and R3 switched on = 1.0 Ohms), R2 II R3 (R2 and R3 switched on = 0.83 Ohms), and R1 II R2 II R3 (R1, R2, R3 switched on = 0.71 Ohms). If the power supply outputs 100 V, for example, with the resistor set up just described, the magnitude of the minimum current portions of the welding waveforms can be adjusted from 20A to 140A in 20A increments (20A, 40A, 60A, 80A, 100A, 120A, 140A). Adding additional individually switched resistors to the adjustable resistance will allow for the selection of more than seven different minimum current magnitudes for the welding waveform.

Through the user interface on the power supply or wire feeder, the adjustable resistance level can be set manually by an operator. Alternatively or additionally, the controller 24 in the wire feeder 14 or the controller 46 in the power supply (Fig. 3) can automatically set the resistance level of the adjustable resistance, to thereby set the magnitude of minimum current portions of the welding waveform. A controller can automatically adjust the resistance level of the adjustable resistance based on one or more welding parameters. For example, at higher electrode wire feed speeds, the adjustable resistance can be set to a lower level, to increase the minimum current level so that the electrode is adequately burned off at the higher wire feed speed. Conversely, a controller can automatically increase the resistance of the adjustable resistance at lower wire feed speeds to reduce the minimum current level. Providing an adjustable minimum current level based on wire feed speed can improve welding performance (e.g., promote arc stability), in particular between pinch current portions and the plasma boost pulses during STT welding.

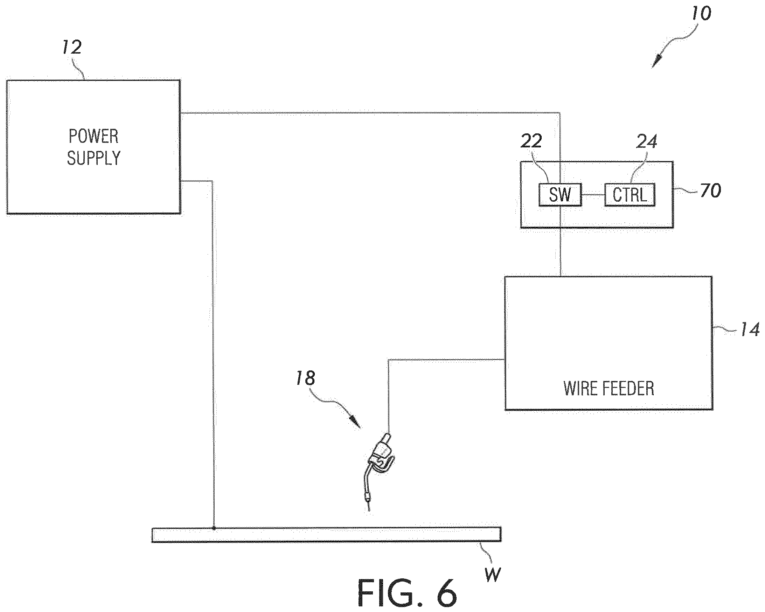

The STT subcircuit (switch and parallel resistor) have been described above as being included in the wire feeder 14, such as within a housing for the wire feeder. However, the STT switch 22, parallel resistor and controller 24 need not be located within the wire feeder 14, but could be configured as an add-on device. Figure 6 shows an add-on remote STT switch 70 that can be inserted (e.g., plugged in) along the welding circuit, such as between the power supply 12 and wire feeder 14. The add-on remote STT switch 70 is a stand-alone device that is separate from both power supply 12 and wire feeder 14 and used locally at the wire feeder.

It should be evident that this disclosure is by way of example and that various changes may be made by adding, modifying or eliminating details without departing from the fair scope of the teaching contained in this disclosure. The invention is therefore not limited to particular details of this disclosure except to the extent that the following claims are necessarily so limited.

**REFERENCE NUMBERS**

| | | | |
|---|---|---|---|
| 10 | welding system | 40 | contact tip |
| 12 | welding power supply | 46 | controller |
| 14 | wire feeder | 48 | voltage sensor |
| 16 | power cable | 50 | background current portion |
| 18 | welding torch | 52 | pinch current portion |
| 20 | grounding clamp | 54 | plasma boost pulse |
| 22 | STT switch | 56 | tail out |
| 24 | controller | 58a | minimum current portion |
| 26 | electric arc | 58b | minimum current portion |
| 28 | welding electrode | 62 | voltage sensor |
| 30 | inverter | 64 | switch |
| 32 | input rectifier | 66 | switch |
| 34 | transformer | 68 | switch |
| 36 | output rectifier | 70 | add-on remote STT switch |
| 38 | parallel resistor | | |

## Claims

1. A welding system (10), comprising:
a power supply (12) configured to output a series of welding waveforms for generating a welding current in a consumable welding electrode (28);
a wire feeder (14) that advances the consumable welding electrode (28) toward a weld puddle during a welding operation, wherein the wire feeder (14) comprises:
a subcircuit comprising a switching device and parallel resistance, said subcircuit being connected in series with the consumable welding electrode (28) such that the welding current flows through the subcircuit, wherein the switching device is controllable between a conducting state and a nonconducting state; and
a controller (46) operatively connected to the switching device and configured to control switching operations of the switching device,
wherein the power supply (12) is configured to remotely identify occurrences of the switching operations in the wire feeder (14) and control the welding waveforms based on the occurrences of the switching operations.

2. The welding system (10) of claim 1, wherein the wire feeder (14) communicates the switching operations to the power supply (12).

3. The welding system (10) of claim 1 or 2, wherein the power supply (12) remotely identifies the occurrences of the switching operations in the wire feeder (14) based on a sensed welding condition and controls timing of portions of the welding waveforms based on the sensed welding condition.

4. The welding system (10) of any of the claims 1 to 3, wherein the controller (46) controls timing of the switching operations of the switching device based on rate of change of welding voltage, and the power supply (12) remotely identifies the occurrences of the switching operations in the wire feeder based on rate of change of the welding current,
wherein, preferably, the power supply (12) controls timing of portions of the welding waveforms based on the rate of change of the welding current.

5. The welding system of any of the claims 1 to 4, wherein the power supply (12) is configured to remotely identify occurrences of the switching operations of the switching device from the conducting state to the nonconducting state and also from the nonconducting state to the conducting state,
wherein, preferably, the power supply (12) controls timing of portions of the welding waveforms based on the switching device switching from the nonconducting state to the conducting state.

6. A welding system (10), comprising:
a power supply (12) configured to control a first portion of a welding waveform and a second portion of a welding waveform, for generating a welding current in a consumable welding electrode (28);
a wire feeder (14) that advances the consumable welding electrode (28) toward a weld puddle during a welding operation, wherein the wire feeder (14) comprises:
a subcircuit comprising a switching device and parallel resistance, said subcircuit being connected in series with the consumable welding electrode (28) such that the welding current flows through the subcircuit, wherein the switching device is controllable between a conducting state and a nonconducting state; and
a controller (46) operatively connected to the switching device and configured to control switching operations of the switching device between the conducting state and the nonconducting state to generate a low current portion of the welding waveform between the first portion of the welding waveform and the second portion of the welding waveform,
wherein the power supply (12) comprises a welding current sensor, and the power supply (12) is configured to determine occurrences of the switching operations in the wire feeder (14) based on sensed welding current and control a timing of at least one of the first portion of the welding waveform and the second portion of the welding waveform with respect to the low current portion.

7. The welding system (10) of any of the claims 1 to 6, further comprising a power cable (16) conducting the welding current from the power supply (12) to the wire feeder (14), wherein the power supply (12) and/or the wire feeder communicate over the power cable (16), and/or wherein the power supply and/or the wire feeder (14) are configured to communicate information to the power supply over the power cable.

8. The welding system (10) of claim 6 or 7, wherein the wire feeder (14) is configured to communicate a welding parameter adjustment to the power supply (12) over the power cable (16).

9. The welding system (10) of any of the claims 6 to 8, wherein the wire feeder (14) is located remote from the power supply (12) in a separate housing from the power supply (12).

10. The welding system (10) of any of the claims 6 to 9, wherein the controller (46) controls timing of the switching operations of the switching device based on rate of change of welding voltage, and the power supply (12) determines occurrences of the switching operations in the wire feeder (14) based on rate of change of the welding current, wherein, preferably, the power supply (12) is configured to determine occurrences of the switching operations of the switching device from the conducting state to the nonconducting state and also from the nonconducting state to the conducting state.

11. A welding system (10), comprising:
a power supply (12) comprising an inverter controlled to generate a series of welding waveforms;
a wire feeder (14), located remote from the power supply (12), that advances a consumable welding electrode (28) toward a weld puddle during a welding operation, wherein the consumable welding electrode (28) is operatively connected to the power supply (12) to conduct a welding current comprising the welding waveforms to a workpiece;
a subcircuit comprising a switching device and parallel resistance, said subcircuit being connected in series with the consumable welding electrode (28) such that the welding current flows through the subcircuit, wherein the switching device is controllable between a conducting state and a nonconducting state; and
a controller (46) operatively connected to the switching device and configured to control switching operations of the switching device, wherein the controller and subcircuit are located remote from the power supply (12) and local to the wire feeder (14),
wherein the power (12) is configured to remotely identify occurrences of the switching operations of the switching device and control timing of operations of the inverter with respect to the switching operations of the switching device.

12. The welding system (10) of claim 11, wherein:
the subcircuit and wire feeder are located together in a separate housing from the power supply (12),
the welding system (10) further comprises a power cable (16) conducting the welding current from the power supply (12) to the wire feeder (14), and
the wire feeder (14) is configured to communicate a welding parameter adjustment to the power supply (12) over the power cable (16).

13. The welding system (10) of claim 11 or 12, wherein the power supply (12) comprises a welding current sensor and controls timing of portions of the welding waveforms based on a sensed rate of change of the welding current, and/or
wherein the power supply (12) is configured to remotely identify occurrences of the switching operations of the switching device from the conducting state to the nonconducting state and also from the nonconducting state to the conducting state, and/or
wherein the power supply (12) controls timing of portions of the welding waveforms based on the switching device switching from the nonconducting state to the conducting state.

14. The welding system (10) of any of the claims 11 to 13, wherein the resistance is an adjustable resistance comprising a plurality of individually switched resistances connected in parallel.

15. The welding system (10) of any of the claims 11 to 14, wherein the controller (46) is configured to automatically adjust a resistance level of the adjustable resistance based on a wire feed speed at which the wire feeder (14) advances the consumable welding electrode (28).
